# EUROPEAN PATENT APPLICATION

(11) **EP 4 801 209 A2**
(43) Date of publication of application: **02.09.2026**
(21) Application number: 26155012.3
(22) Date of filing: 29.01.2026
(51) Int. Cl.: H05K 7/14, F16B 21/06, F16B 43/00

(54) **FASTENER SYSTEM**

(30) Priority: 07.02.2025 US 202519048282
(71) Applicant: Tesla, Inc., Austin, TX 78725 (US)
(72) Inventor: SHENDEL, Gregory John, Austin, Texas, 78725 (US); VANNESS, Justin William, Austin, Texas, 78725 (US); WHITFORD, Daniel J., Austin, Texas, 78725 (US); PUTNEY, Samuel, Austin, Texas, 78725 (US)
(74) Representative: Liesegang, Eva

(57) **Abstract**

Generally described, one or more aspects of the present disclosure relate to threadless fastening systems, and components thereof, the threadless fastening system including a fastening washer including a conical spring, a retaining cup comprising one or more washer centering ribs, and an attachment pin, wherein the fastening washer is configured to press fit onto an interface surface of the attachment pin, and wherein the conical spring is configured to generate a joint preload between the fastening washer and attachment pin clamp surface.

## Description

This application claims the benefit of priority to U.S. Patent Application No. 19/048,282, entitled "FASTENER SYSTEM," filed on February 7, 2025, which is hereby incorporated by reference in its entirety and for all purposes.

### BACKGROUND

### Field

The present disclosure relates to a fastener system. More specifically, the present disclosure relates to a self-retaining fastening washer and systems thereof. The fastener system can be employed to attach a printed circuit board assembly to a heatsink.

### Description of the Related Art

Many types of fasteners may structurally, thermally, and electrically connect a printed circuit board assembly to a heatsink. However, these fasteners may be time consuming to install. These fasteners may also be supplied as discrete parts, which can cause additionally difficulties in the assembly process. Additionally, these fasteners may have a high failure rate during installation due to dropped fasteners, cross or false threading, or joint preload variability which can cause loose fasteners. Thus, using such fastening systems can result in a low process yield and/or high failure rates during assembly.

### SUMMARY

For purposes of summarizing the invention and the advantages achieved over the prior art, certain objects and advantages of the invention are described herein. Not all such objects or advantages may be achieved in any particular embodiment of the invention. Thus, for example, those skilled in the art will recognize that the invention may be embodied or carried out in a manner that achieves or optimizes one advantage or group of advantages as taught herein without necessarily achieving other objects or advantages as may be taught or suggested herein.

In some aspects, a threadless fastener system for securing a printed circuit board assembly (PCBA) to an attachment pin is disclosed, where the attachment pin extends from a heatsink and includes a clamping surface spaced from the heatsink. The clamping surface is configured to support the PCBA. The threadless fastener system includes a fastening washer having a conical spring and a plurality of interference petals, the plurality of interference petals being sized and shaped to clamp to the attachment pin, and a retaining cup sized and shaped to receive the fastening washer, a portion of the retaining cup being disposed between the fastening washer and the PCBA when the plurality of interference petals are clamped to the attachment pin, where the conical spring creates a thermally stable clamping force on the PCBA between the clamping surface and the portion of the retaining cup when the plurality of interference petals are clamped to the attachment pin.

In some aspects, a fastening washer configured for securement to an attachment pin is described. The fastening washer includes a conical spring having an inner edge and an outer edge, a flat outer rim extending from the outer edge of the conical spring, an integrated press surface extending inward from the inner edge, and a plurality of interference petals arranged inward from the integrated press surface.

In some embodiments, the fastening washer further includes an opening at a center of the plurality of interference petals. In some embodiments, the inner edge and the outer edge are circular and concentric. In some embodiments, the fastening washer further includes one or more gaps extending radially through a portion of the conical spring. In some embodiments, the integrated press surface is substantially parallel to the flat outer rim. In some embodiments, the plurality of interference petals are configured to mechanically grip the attachment pin. In some embodiments, the fastening washer further comprises stainless steel. In some embodiments, the fastening washer further comprises a height from the flat outer rim to the plurality of interference petals, wherein the height is about 2 mm. In some embodiments, an outer diameter of the flat outer rim is about 13 mm. In some embodiments, a diameter of the opening is about 2.75 mm.

In some aspects, a threadless fastener system is described. The threadless fastener system includes a retaining cup having a cup clamping surface, a fastening washer comprising a conical spring positioned within the retaining cup, and an attachment pin having an interface surface and a pin clamping surface, where an end of the attachment pin is configured to attach to a first item, where the fastening washer is configured to clamp on the interface surface, and where the conical spring is configured to generate a clamping force on a second item positioned between the cup clamping surface and the pin clamping surface.

In some embodiments, the cup clamping surface is spaced a distance away from the end of the attachment pin. In some embodiments, the interface surface is electrically conductive. In some embodiments, the retaining cup further comprises one or more washer centering wedges. In some embodiments, the clamping force is at least 300 N. In some embodiments, the retaining cup further comprises a washer press distance limiting feature. In some embodiments, the retaining cup further comprises one or more snap retainers. In some embodiments, the first item is a heatsink and the heatsink is fixedly attached to the attachment pin. In some embodiments, the second item is a PCBA.

### BRIEF DESCRIPTION OF THE DRAWINGS

The present inventions are described with reference to the accompanying drawings, in which like reference characters reference like elements, and wherein:
FIG. 1 is a perspective illustration of a threadless fastener system according to the disclosure.
FIG. 2 is a front section illustration of the threadless fastener system of FIG. 1 that includes a retaining cup, a fastening washer, and an attachment pin.
FIG. 3 is a perspective illustration of the fastening washer from FIG. 1.
FIG. 4 is a perspective illustration of the retaining cup from FIG. 1.
FIG. 5 is a front illustration of the attachment pin from FIG. 1.

### DETAILED DESCRIPTION

The following detailed description of certain embodiments presents various descriptions of specific embodiments. However, the innovations described herein can be embodied in a multitude of different ways, for example, as defined and covered by the claims. In this description, reference is made to the drawings where like reference numerals and/or terms can indicate identical or functionally similar elements. It will be understood that elements illustrated in the figures are not necessarily drawn to scale. Moreover, it will be understood that certain embodiments can include more elements than illustrated in a drawing and/or a subset of the elements illustrated in a drawing. Further, some embodiments can incorporate any suitable combination of features from two or more drawings. The headings are provided for convenience only and do not impact the scope or meaning of the claims.

Generally described, one or more aspects of the present disclosure relate to a threadless fastener system which can include a self-retaining fastening washer. The threadless fastener system can attach a printed circuit board assembly (PCBA) to a heatsink while spacing the PCBA apart from the heatsink. The threadless fastener system can secure a PCBA to an attachment pin. The threadless fastener system can advantageously maintain a set gap between the PCBA and the heatsink. The threadless fastener system can include a self-retaining fastening washer which includes a conical spring. The threadless fastener system can advantageously improve the speed and accuracy of assembling the PCBA on the heatsink in part because multiple fastening washers can be pressed simultaneously to attach one or more PCBAs on the heatsink. While the description herein describes the threadless fastener system attaching a PCBA to a heatsink, it should be understood that the threadless fastener system may be used to attach any first item to any second item using the embodiments or subset of embodiments herein described.

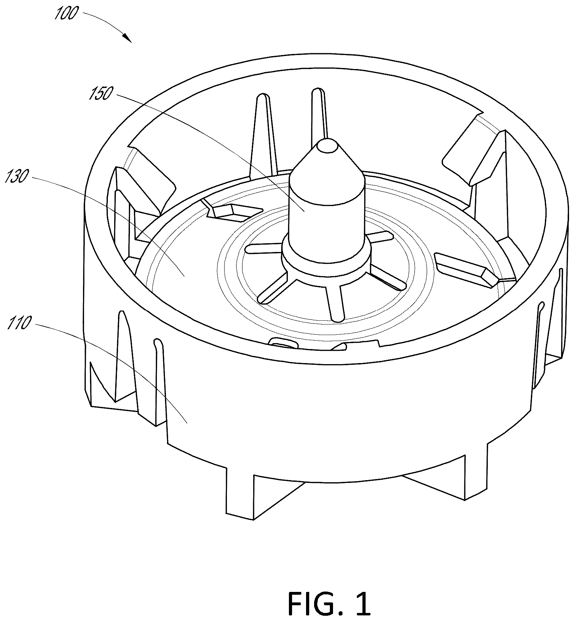

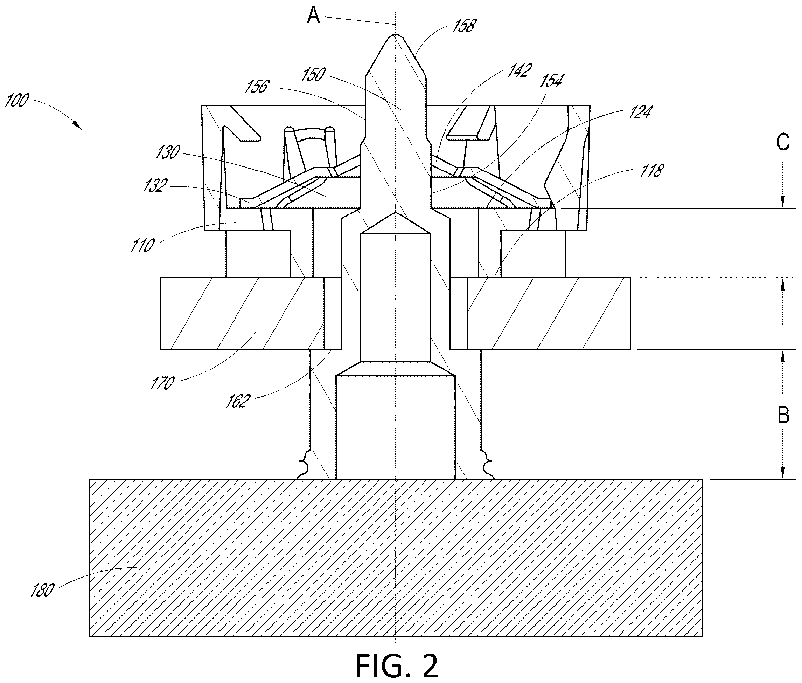

FIGS. 1 and 2 illustrate a threadless fastener system 100 according to the disclosure. As shown in FIG. 1, the threadless fastener system 100 includes a retaining cup 110, a fastening washer 130, and an attachment pin 150. In certain embodiments, the fastening washer 130 is positioned within the retaining cup 110. In certain embodiments, the attachment pin 150 extends through a center of the fastening washer 130 when assembled. The threadless fastener system 100 can advantageously structurally, thermally, and electrically connect a printed circuit board assembly 170 to a heatsink 180.

In some embodiments, as illustrated in FIG. 2, the threadless fastener system 100 can attach the PCBA 170 to the heatsink 180. As shown in FIG. 2, the attachment pin 150 extends proximally from a distal surface of the heatsink 180. In some embodiments, the attachment pin 150 is fixedly attached to the heatsink 180. The attachment pin 150 can include a circular or substantially circular perimeter and have a central axis A. The attachment pin 150 can include a clamping surface 162. The clamping surface 162 can be positioned a distance B away from the heatsink 180. In some examples, the distance B can be between 0 mm and 30 mm. In some examples, the distance B can be, be about, be at least, 1 mm, 1.1 mm, 1.2 mm, 1.3 mm, 1.4 mm, 1.5 mm, 1.6 mm, 1.7 mm, 1.8 mm, 1.9 mm, 2.0 mm, 2.1 mm, 2.2 mm, 2.3 mm, 2.4 mm, 2.5 mm, 2.6 mm, 2.7 mm, 2.8 mm, 2.9 mm, 3.0 mm, 4 mm, 5 mm, 6 mm, 7 mm, 8 mm, 9 mm, 10 mm, 11 mm, 12 mm, 13 mm, 14 mm, 15 mm, 16 mm, 17 mm, 18 mm, 19 mm, 20 mm, 21 mm, 22 mm, 23 mm, 24 mm, 25 mm, 26 mm, 27 mm, 28 mm, 29 mm, 30 mm or any range thereof. The clamping surface 162 can be substantially perpendicular to the central axis A and substantially parallel to the distal surface of the heatsink 180 in certain embodiments. In certain embodiments, the clamping surface 162 can be rectangular, triangular, or include a portion of the circumference of the attachment pin 150. The PCBA 170 can be positioned to sit on the clamping surface 162 in certain embodiments. The retaining cup 110 can be positioned distal from the clamping surface 162 and is positioned on the opposite side of the PCBA 170 from the clamping surface 162. The fastening washer 130 can be positioned within the retaining cup 110.

The fastening washer 130 can mechanically grip (e.g., clamp onto via a friction and/or an interference fit) an interface surface 154 of the attachment pin 150. The interface surface 154 can be a cylindrical surface which extends distally from the clamping surface 162 in certain embodiments. In certain embodiments, the interface surface 154 can be smooth. In certain embodiments, some or all of the interface surface 154 can be textured, knurled, ribbed, stepped, etc. The fastening washer 130 can be positioned on a retaining cup washer surface 124 of the retaining cup 110. A press force can be applied in a proximal direction to the fastening washer 130, parallel to the attachment pin 150 axis. This press force can cause the fastening washer 130 to flex a press distance and clamp onto the interface surface 154. The press force generates a clamp load on the fastening washer 130 so that the fastening washer 130 presses against the retaining cup 110 and fastens the PCBA 170 between the clamping surface 162 and a cup clamping surface 118 which contacts the PCBA 170. Advantageously, the attachment pin 150 supports the PCBA once fastened together. In some embodiments, the retaining cup washer surface 124 is spaced a distance C apart from the cup clamping surface 118. In some examples, the distance C is between 0.5 mm and 10 mm. In some examples, the distance C can be, can be about, can be at least 0.5 mm, 0.6 mm, 0.7 mm, 0.8 mm, 0.9 mm, 1 mm, 1.1 mm, 1.2 mm, 1.3 mm, 1.4 mm, 1.5 mm, 1.6 mm, 1.7 mm, 1.8 mm, 1.9 mm, 2.0 mm, 2.1 mm, 2.2 mm, 2.3 mm, 2.4 mm, 2.5 mm, 2.6 mm, 2.7 mm, 2.8 mm, 2.9 mm, 3.0 mm, 4 mm, 5 mm, 6 mm, 7 mm, 8 mm, 9 mm, 10 mm or any range thereof.

Advantageously, the threadless fastener system 100 provides electrical creepage and clearance separation to nearby high voltage electrical components and traces on the PCBA 170 because the retaining cup 110 can be electrically insulating and the fastening washer 130 can have a clearance to the surfaces of the PCBA 170. The retaining cup 110 may include creepage surfaces between the fastening washer 130 and surfaces of the PCBA 170. The threadless fastener system 100 also can advantageously maintain a thermally stable clamping force, such that the clamping force can be maintained through thermal cycling conditions and various thermal conditions (e.g., extremely high temperatures, extremely low temperatures, and sudden transitions therebetween).

In some examples, the clamping force can be between 10 N and 1500 N with a press distance of between 0.5 mm and 1.0 mm. In some examples, the press distance can be at least, or at least about 0.3 mm, 0.4 mm, 0.5 mm, 0.6 mm, 0.7 mm, 0.8 mm, 0.9 mm, 1.0 mm, 1.1 mm, 1.2 mm, 1.3 mm, or any range of values therebetween. In some examples, the clamping force generated can be at least, or at least about 10 N, 50 N, 100 N, 150 N, 200 N, 210 N, 220 N, 230 N, 240 N, 250 N, 260 N, 270 N, 280 N, 290 N, 300 N, 310 N, 320 N, 330 N, 340 N, 350 N, 360 N, 370 N, 380 N, 390 N, 400 N, 410 N, 420 N, 430 N, 440 N, 450 N, 460 N, 470 N, 480 N, 490 N, 500 N, 550 N, 600 N, 650 N, 700 N, 750 N, 800 N, 850 N, 900 N, 950 N, 1000 N, 1050 N, 1100 N, 1150 N, 1200 N, 1250 N, 1300 N, 1350 N, 1400 N, 1450 N, 1500 N or any range of values therebetween. In some examples, the fastening washer 130 can tolerate between a 0.01 mm change in height and a 0.75 mm change in height before a loss of clamping force occurs. In some examples, the height loss can be at least, or at least about 0.01 mm, 0.1 mm, 0.2 mm, 0.25 mm, 0.3 mm, 0.35 mm, 0.4 mm, 0.45 mm, 0.5 mm, 0.55 mm, 0.60 mm, 0.65 mm, 0.70 mm, 0.75 mm or any range of values therebetween in either a proximal or a distal direction before a loss of clamping force occurs.

In some examples, a plurality of the threadless fastener systems 100 can be used to fully attach the PCBA 170 to the heatsink 180. The plurality threadless fastener assemblies can be spaced around the surface of the PCBA 170 and the heatsink 180 to form a stable connection between the PCBA 170 and the heatsink 180. The PCBA 170 can be assembled to attach to the heatsink 180 with a method which can include the following steps. An adhesive material can be dispensed in each location where a retaining cup 110 will be installed. In certain embodiments, the retaining cup 110 includes metal features and the retaining cup 110 can be soldered to the PCBA 170. A washer assembly including a retaining cup 110 holding a pre-installed fastening washer 130 can be installed on the PCBA 170 via a pick and place machine from tape and reel packaging to place the washer assembly on the adhesive material. The PCBA 170 can be passed through a reflow oven to cure the adhesive material. In certain embodiments, the adhesive material can be cured separately. A manufacturing line can receive the PCBA 170 with the installed washer assemblies. One or more of the PCBA 170 assemblies can be placed onto a heatsink 180 which has an attachment pin 150 corresponding to each washer assembly. The attachment pins 150 can be integral to the heatsink 180. The retaining cup 110 of the washer assemblies can transfer an external press force to press the PCBA 170 on to the clamping surface 162 of the attachment pin 150 prior to loading the fastening washer 130. This press force can be used to wet-out a thermal interface material between the PCBA 170 and the heatsink 180. A press force is supplied to each of the fastening washers 130. The press force attaches each fastening washer 130 to an attachment pin 150. This method of assembly advantageously allows for each of the fastening washers 130 to be fastened to an attachment pin 150 simultaneously, thereby reducing assembly time. The shape and tolerances of the threadless fastener system 100 described herein also advantageously increases the robustness of the tolerance stack ups between the components. The washer assembly can accommodate a plurality of attachment pins 150 across a heatsink 180. In certain embodiments, the different attachment pins may have a variety of heights across the heatsink 180. The fastening washer 130 may float relative to the retaining cup 110, thereby allowing the fastening washer 130 to move freely within the retaining cup 110 relative to the attachment pin 150, thereby reducing the chances of misalignment between the components of the threadless fastener system 100.

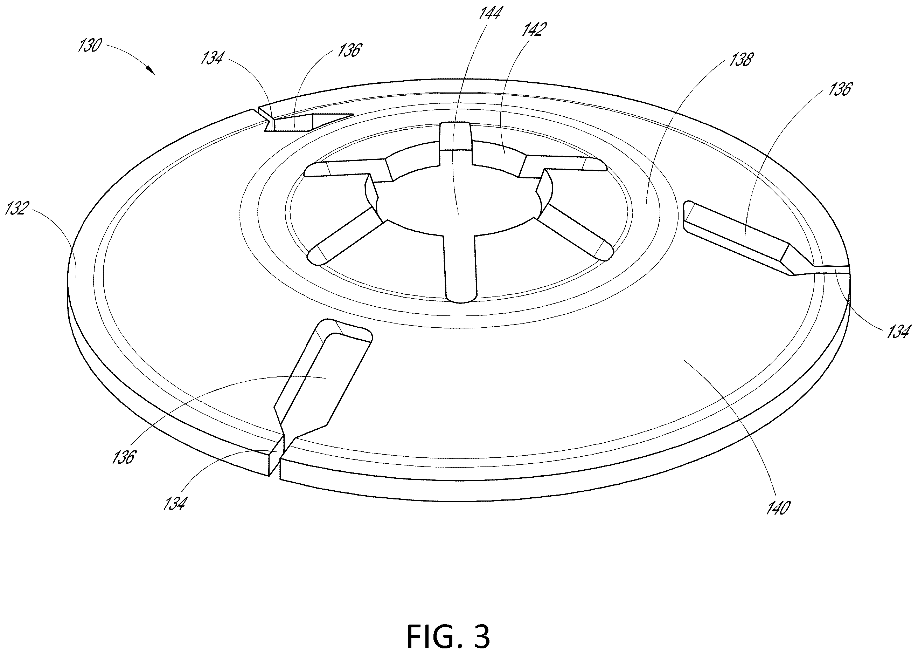

FIG. 3 illustrates a perspective view of a fastening washer 130 according to the disclosure. As illustrated, the fastening washer 130 can include a conical spring 140 which can include a surface having the shape of a frustum of a cone. The surface forms a circular inner edge and a circular outer edge in certain embodiments. An outer rim 132 can extend outward from the outer edge of the conical spring 140. The outer rim 132 can extend outward perpendicular to the axis of the fastening washer 130 in certain embodiments. The outer rim 132 can be a substantially planar ring in certain embodiments. The conical spring 140 can extend at an angle inward from the outer rim 132. For example, the conical spring 140 can extend at an angle between 15 and 40 degrees from the outer rim 132.

An integrated press surface 138 can extend inward from the inner edge of the conical spring 140. The press surface 138 can extend inward perpendicular to the axis of the fastening washer 130 in certain embodiments. The integrated press surface 138 can be a substantially planar ring in certain embodiments. The integrated press surface 138 can be parallel to the outer rim 132. A plurality of interference petals 142 can be arranged inward from the integrated press surface 138 in certain embodiments. The plurality of interference petals 142 can extend at an angle from the integrated press surface 138. In some examples, the fastening washer 130 includes 2, 3, 4, 5, 6, 7, 8, 9, 10, 11, 12 or more interference petals 142, or any range thereof. An opening 144 can be positioned at the center of the plurality of interference petals 142. The opening 144 can be a central opening and can have a diameter approximately equal to or smaller than the interface surface 154 of the attachment pin 150 described herein. In some embodiments, the fastening washer 130 can have a height between 0.5 mm and 10 mm. In some examples, the fastening washer 130 can have a height of, of about, or of at least about 0.5 mm, 0.6 mm, 0.7 mm, 0.8 mm, 0.9 mm, 1.0 mm, 1.1 mm, 1.2 mm, 1.3 mm, 1.4 mm, 1.5 mm, 1.6 mm, 1.7 mm, 1.8 mm, 1.9 mm, 2.0 mm, 2.1 mm, 2.2 mm, 2.3 mm, 2.4 mm, 2.5 mm, 2.6 mm, 2.7 mm, 2.8 mm, 2.9 mm, 3.0 mm, 3.5 mm, 4 mm, 4.5 mm, 5 mm, 5.5 mm, 6 mm, 6.5 mm, 7 mm, 7.5 mm, 8 mm, 8.5 mm, 9 mm, 9.5 mm, 10 mm or any range of values therebetween. In some embodiments, the fastening washer 130 can have an outer diameter between 8 mm and 35 mm. In some examples, the fastening washer 130 can have an outer diameter of, of about, or of at least about 8 mm, 9 mm, 10 mm, 10.5 mm, 11 mm, 11.5 mm, 12 mm, 12.5 mm, 13 mm, 13.5 mm, 14 mm, 14.5 mm, 15 mm, 15.5 mm, 16 mm, 17 mm, 18 mm, 19 mm, 20 mm, 21 mm, 22 mm, 23 mm, 24 mm, 25 mm, 26 mm, 27 mm, 28 mm, 29 mm, 30 mm, 31 mm, 32 mm, 33 mm, 34 mm, 35 mm or any range of values therebetween. In some embodiments, the fastening washer 130 can have an inner diameter between 1 mm and 15 mm. In some examples, the fastening washer 130 can have an inner diameter of, of about, or of at least about 1.0 mm, 1.1 mm, 1.2 mm, 1.25 mm 1.3 mm, 1.4 mm, 1.5 mm, 1.6 mm, 1.7 mm, 1.75 mm 1.8 mm, 1.9 mm, 2.0 mm, 2.1 mm, 2.2 mm, 2.25 mm, 2.3 mm, 2.4 mm, 2.5 mm, 2.6 mm, 2.7 mm, 2.75 mm, 2.8 mm, 2.9 mm, 3.0 mm, 3.1 mm, 3.2 mm, 3.25 mm 3.3 mm, 3.4 mm, 3.5 mm, 3.6 mm, 3.7 mm, 3.75 mm, 3.8 mm, 3.9 mm, 4.0 mm, 5 mm, 6 mm, 7 mm, 8 mm, 9 mm, 10 mm, 11 mm, 12 mm, 13 mm, 14 mm, 15 mm or any range of values therebetween. The fastening washer 130 can have a thickness of, of about, or of at least about 0.5 mm, 1.0 mm, 1.25 mm, 1.5 mm, 1.75 mm, 2.0 mm, 2.25 mm, 2.5 mm, 2.75 mm, 3.0 mm, 3.25 mm, 3.5 mm, 3.75 mm, 4 mm, 4.25 mm, 4.5 mm, 4.75 mm, 5.0 mm or any range of values therebetween. The fastening washer 130 can have a variable thickness. The fastener washer 130 may include a petal thickness and an outer spring thickness. The petal thickness can be the fastener washer 130 thickness proximal to the interference petals 142. The outer spring thickness can be the thickness proximal to the outer radius of the fastener washer 130. In some examples, the petal thickness differs from the outer spring thickness. In some examples, the petal thickness is thicker than the outer spring thickness. In some examples, the petal thickness is thinner than the outer spring thickness. In some examples, the conical spring 140 can have a variable thickness. In some examples, the conical spring 140 can have the same thickness as the outer spring thickness. The thickness of the fastener washer 130 can influence the press-force required to clamp and pre-load the fastening washer 130.

The outer rim 132 can advantageously reduce the press-force required to clamp and pre-load the fastening washer 130. The outer rim 132 can be angled slightly distally, thereby forming a smooth surface when the fastening washer 130 width expands during installation. The angled outer rim 132 advantageously inhibits the outer edge of the outer rim 132 from digging into the retaining cup 110. The outer rim 132 can also advantageously improve the pre-load retention over time of the fastening system 100 by increasing the surface contact area between the fastening washer 130 and the retaining cup 110, which thereby reduces the pressure on the retaining cup 110. The reduced pressure can reduce creep or stress relaxation of the retaining cup 110.

The integrated press surface 138 can advantageously limit or reduce the side-loading seen by the fastening washer 130 when a press force is applied to the fastening washer 130. The integrated press surface 138 also advantageously provides a separation between the plurality of interference petals 142 and the conical spring 140. This can advantageously reduce any deformation to the plurality of interference petals 142 due to the pre-loading of the conical spring 140.

The fastening washer 130 can include a plurality of spring gaps 136 located in the conical spring 140. The spring gaps 136 can advantageously reduce the stiffness of the conical spring 140 which can control the clamp load generated by the fastening washer 130. The spring gaps 136 can prevent small press distance variations from causing large clamp load variations. The spring gaps 136 can be positioned adjacent to the outer rim 132 and can extend radially inward across some or substantially all of the width of the conical spring 140. In some examples, the width which the spring gaps 136 extend radially inward can adjust the stiffness of the conical spring 140. For example, the longer the spring gaps 136 extend radially inward, the lower the stiffness of the conical spring 140. A small gap 134 can extend radially from each spring gap 136 across the outer rim 132 in certain embodiments. The narrow width of the small gap 134 can advantageously reduce or inhibit some or all tangling of fastening washers 130 during an assembly process, for example, in a bowl feeding apparatus.

In some examples, the fastening washer 130 can be made of aluminum, stainless steel (e.g., 301 SST, 304 SST, or 316 SST), titanium, or steel. In some examples, the fastening washer 130 can be magnetic. In some embodiments, the fastening washer 130 can be work hardened and/or heat treated. In certain embodiments, the fastening washer 130 can also be surface treated (e.g., passivated, electroplated, painted, or anodized).

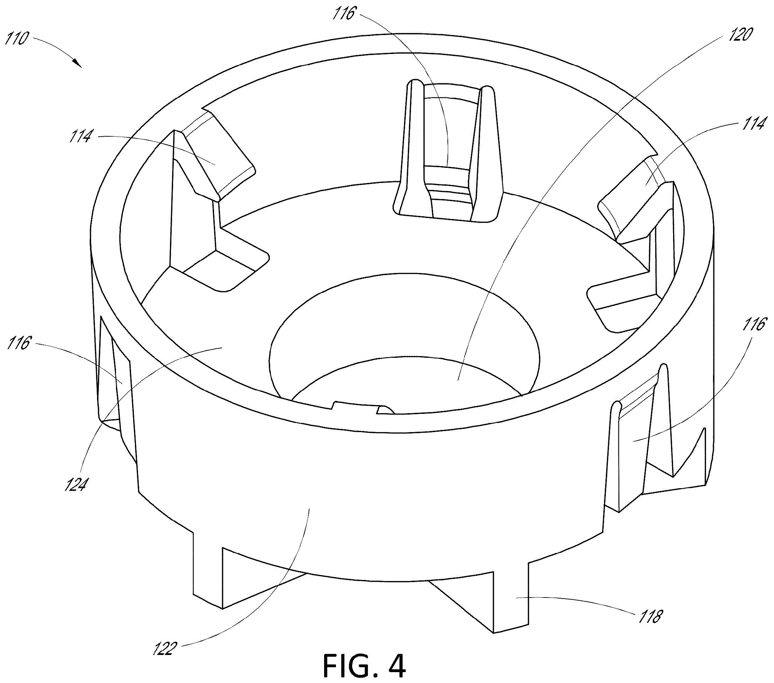

FIG. 4 illustrates a perspective view of a retaining cup 110 according to the disclosure. The retaining cup 110 has a generally cylindrical shape and includes a cup clamping surface 118 positioned at a proximal end of the retaining cup 110. A retaining cup washer surface 124 is positioned distally from the cup clamping surface 118. The retaining cup washer surface 124 can be substantially planar with a circular wall 122 extending distally from the retaining cup washer surface 124 to form a cup like shape. The circular wall 122 can have an internal diameter such that a fastening washer 130 can be positioned interior to the circular wall 122 with a clearance fit. In some embodiments, the circular wall 122 can have an inner diameter between 9 and 40 mm. In some examples, the circular wall 122 can have an inner diameter of, of about, or of at least about 9 mm, 10 mm, 10.5 mm, 11 mm, 11.5 mm, 12 mm, 12.5 mm, 13 mm, 13.5 mm, 14 mm, 14.5 mm, 15 mm, 15.5 mm, 16 mm, 16.5 mm, 17 mm, 17.5 mm, 18 mm, 20 mm, 22 mm, 24 mm, 26 mm, 28 mm, 30 mm, 32 mm, 34 mm, 36 mm, 38 mm, 40 mm or any range of values therebetween. In some examples, the distal edge of the circular wall 122 can act as a hard stop for a pressing tool for installing the fastening washer 130.

The height of the circular wall 122 can be defined so that a maximum displacement of the fastening washer 130 is not exceeded when the fastening washer 130 is installed, thereby limiting the force generated in the joint. The height of the circular wall 122 can define the preload force between the fastening washer 130 and the attachment pin 150 by limiting a press surface displacement. The preload force between the fastening washer 130 and the attachment pin 150 can also be limited by force feedback on a press apparatus. A central opening 120 can extend through the center of the retaining cup washer surface 124.

A plurality of snap retainers 114 can retain the fastening washer 130 interior to the circular wall 122. The plurality of snap retainers 114 can be spaced around the internal perimeter of the circular wall 122 in certain embodiments. The snap retainer 114 is sized such that the fastening washer 130 can be pressed from a proximal side to a distal side of the snap retainer 114 such that the fastening washer 130 is then captured and inhibited from rattling out of or falling out of the retaining cup 110. In some examples, the snap retainers 114 can each include a sloped proximal surface and a blunt distal surface. The snap retainers 114 can be spaced near the distal edge of the circular wall 122 such that the snap retainers 114 will not contact the fastening washer 130 once the fastening washer 130 is pressed into the retaining cup 110. In some examples, the retaining cup includes 1,2, 3, 4, 5, 6, 7, 8, 9, 10, or more snap retainers 114, or any range thereof. In certain embodiments, the fastening washer 130 is retained in the cup by applying heat and pressure to deform the circular wall 122. In certain embodiments, the fastening washer 130 is retained using a tortuous path formed within the circular wall 122. In certain embodiments, the fastening washer 130 is retained by a snap ring inserted into a groove within the circular wall 122.

The retaining cup 110 can also include a plurality of centering wedges 116. The plurality of centering wedges 116 can be positioned proximal from the retaining cup washer surface 124 and distal from the distal surface of the snap retainers 114. The centering wedges 116 can be spaced around the internal perimeter of the circular wall 122 in certain embodiments. The centering wedges 116 can locate the fastening washer 130 so that the opening 144 is substantially concentric with the central opening 120 of the retaining cup 110. The centering wedges 116 can be integral to the retaining cup 110. The centering wedges 116 can be flexibly attached to the circular wall 122. In some examples, the retaining cup 110 includes 1, 2, 3, 4, 5, 6, 7, 8, 9, 10, or more centering wedges 116, or any range thereof. Advantageously, the centering wedges 116 can locate the opening 144 of the fastening washer 130 relative to the central opening 120 of the retaining cup 110, while also providing a gap between the outer edge of the fastening washer 130 and the circular wall 122 of the retaining cup 110 allowing for tolerance variations between the retaining cup 110, fastening washer 130, PCBA 170, and the attachment pin 150 during the assembly of the threadless fastener system 100.

In some examples, the retaining cup 110 can be formed from a nonconductive moldable material which can withstand high and low temperatures. For example, a flame-retardant polymer, such as PBT, PP, silicon, or nylon (e.g., PA 66, PA 6, recycled PA 66).

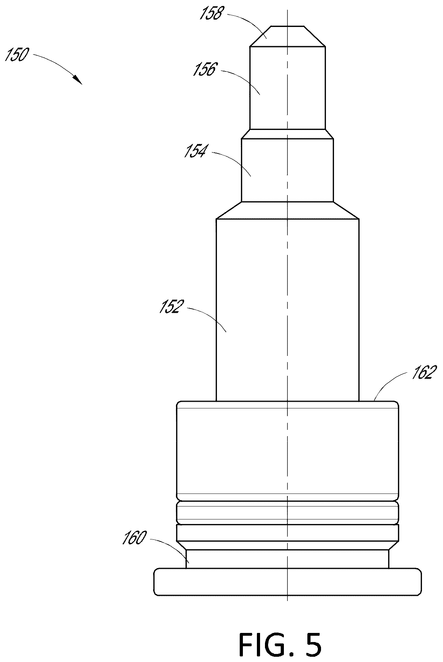

FIG. 5 illustrates an attachment pin 150 according to the disclosure. The attachment pin 150 has a generally circular perimeter and includes a lead-in tip 158 positioned at a proximal end in certain embodiments. In some examples, the lead-in tip 158 has a rounded or flat tip. In some examples, the lead-in tip 158 has a pointed tip. In some examples, the lead-in tip 158 is sloped at an angle between 15 and 75 degrees. For example, 15 degrees, 20 degrees, 25 degrees, 30 degrees, 35 degrees, 40 degrees, 45 degrees, 50 degrees, 55 degrees, 60 degrees, 65 degrees, 70 degrees, 75 degrees or any range of values therebetween.

Distal from the lead-in tip 158, the attachment pin 150 can include a series of cylindrical portions having various diameters and having a common central axis. Each cylindrical portion can extend over a portion of the length of the attachment pin 150. This tiered cylindrical shape can advantageously inhibit the attachment pin 150 from bending. The lead-in tip 158 can pass through the central opening 120 of the retaining cup 110 and the opening 144 of the fastening washer 130.

As illustrated in FIG. 5, a centering surface 156 can be positioned distal from the lead-in tip 158 of the attachment pin 150. The diameter of the centering surface 156 can be sized to have a clearance fit with the central opening 120 of the retaining cup 110 and the opening 144 of the fastening washer 130. The centering surface 156 can orient and center the fastening washer 130 relative to the attachment pin 150 axis.

Distal from the centering surface 156, the attachment pin 150 can include an interface surface 154. The diameter of the interface surface 154 can be sized to have an interference fit with the opening 144 of the fastening washer 130. In some embodiments, the interface surface 154 can have a diameter between 1 mm and 20 mm. In some examples, the interface surface 154 can have a diameter of, of about, or of at least about 1.0 mm, 1.1 mm, 1.2 mm, 1.3 mm, 1.4 mm, 1.5 mm, 1.6 mm, 1.7 mm, 1.8 mm, 1.9 mm, 2.0 mm, 2.1 mm, 2.2 mm, 2.3 mm, 2.4 mm, 2.5 mm, 2.6 mm, 2.7 mm, 2.8 mm, 2.9 mm, 3.0 mm, 3.0 mm, 3.1 mm, 3.2 mm, 3.3 mm, 3.4 mm, 3.5 mm, 3.6 mm, 3.7 mm, 3.8 mm, 3.9 mm, 4.0 mm, 5 mm, 6 mm, 7 mm, 8 mm, 9 mm, 10 mm, 11 mm, 12 mm, 13 mm, 14 mm, 15 mm, 16 mm, 17 mm, 18 mm, 19 mm, 20 mm, or any range of values therebetween. The interface surface 154 can be configured to displace the plurality of interference petals 142 of the fastening washer 130. In some embodiments, the interface surface 154 can include a surface treatment to increase surface roughness and increase a grip force between the interface surface 154 and the interference petals 142. In some embodiments, the interface surface 154 can include machined ridges or a knurled surface to increase a grip force between the interface surface 154 and the interference petals 142.

The attachment pin 150 can include a transition surface between the centering surface 156 and the interface surface 154 so that the transition from the smaller diameter of the centering surface 156 to the larger diameter of the interface surface 154 is not blunt.

The attachment pin 150 can include a pass-through surface 152 distal from the interface surface 154. The pass-through surface 152 can extend through the PCBA 170 and into the retaining cup 110. The diameter of the pass-through surface 152 can be sized to have a clearance fit through an opening in the PCBA 170 and the central opening 120 of the retaining cup 110. The diameter of the pass-through surface 152 can be sized to have a larger interference fit than the interface surface 154. Advantageously, the larger diameter pass-through surface 152 can be used to permanently displace the interference petals 142 around the opening 144 of the fastening washer 130 during an over-press operation. The over-press operation can remove the interference fit between the washer central opening 144 and the pin interface surface 154 and allow the fastening washer 130 to be removed from a previously fastened connection.

At a distal end of the pass-through surface 152, the attachment pin 150 can include a clamping surface 162. The clamping surface 162 can be perpendicular to the central axis of the attachment pin 150 in certain embodiments. The diameter of the clamping surface 162 is wide enough to allow the PCBA 170 to be positioned on the clamping surface 162 as the pass-through surface 152 passes through the PCBA 170. In some examples, the clamping surface 162 can be conductive.

The attachment pin 150 can include an attachment element 160 at a distal end of the attachment pin 150. The attachment element 160 can attach to the heatsink 180. In some examples, the attachment pin 150 can be integral to the heatsink 180. In some examples, the attachment element 160 can be co-molded into the heatsink 180. In some examples, the attachment element 160 can be clinched to the heatsink. In some examples, the attachment element 160 can be pressed into the heatsink with an interference fit. In some examples, the attachment element 160 can be bonded to the heatsink with adhesive, or any of the common metal joining techniques such as soldering, brazing, and welding in all of its forms (e.g., resistance, spin, or friction stir welding.

In some examples the pass-through surface 152 may include one or more parallel fastening surfaces. The fastening surfaces can be flat parallel surfaces which can be clamped by a tool. The fastening surfaces can be clamped to assist in the assembly of the attachment element 160 in the heatsink 180. For example, when threading the attachment element 160 into the heatsink 180. In some examples, the clamping surface 162 can be integral to a clinch nut which can be a component of the heatsink 180. The attachment element 160 of the attachment pin 150 can attach to the clinch nut. In some examples, the attachment element 160 can thread into, or be press-fit into the clinch nut.

The foregoing disclosure is not intended to limit the present disclosure to the precise forms or embodiments disclosed herein. As such, it is contemplated that various alternative forms, embodiments and/or modifications to the present disclosure, whether explicitly described or implied herein, are possible in light of the disclosure. Having thus described embodiments of the present disclosure, a person of ordinary skill in the art will recognize that changes may be made in form and detail without departing from the scope of the present disclosure.

In the foregoing specification, the disclosure has been described with reference to specific embodiments. However, as one skilled in the art will appreciate, various embodiments disclosed herein can be modified or otherwise implemented in various other ways without departing from the spirit and scope of the disclosure. Accordingly, this description is to be considered as illustrative and is for the purpose of teaching those skilled in the art the manner of making and using various embodiments of the disclosed fastening system. It is to be understood that the forms of disclosure herein shown and described are to be taken as representative embodiments. Equivalent elements, or materials may be substituted for those representatively illustrated and described herein. Moreover, certain features of the disclosure may be utilized independently of the use of other features, all of which is apparent to one skilled in the art after having the benefit of this description of the disclosure. Expressions such as "including", "comprising", "incorporating", "consisting of, "have", "is" used to describe and claim the present disclosure are intended to be construed in a non-exclusive manner, namely allowing for items, components or elements not explicitly described also to be present. Reference to the singular is also to be construed to relate to the plural.

Further, various embodiments disclosed herein are to be taken in the illustrative and explanatory sense and should in no way be construed as limiting of the present disclosure. All joinder references (e.g., connected, associated, coupled, and the like) are only used to aid the reader's understanding of the present disclosure, and may not create limitations, particularly as to the position, orientation, or use of the elements disclosed herein. Therefore, joinder references, if any, are to be construed broadly. Moreover, such joinder references may not necessarily infer that two elements are directly connected to each other.

Additionally, all numerical terms, such as, but not limited to, "first", "second", "one", "another", or any other ordinary and/or numerical terms, should also be taken only as identifiers, to assist the reader's understanding of the various elements, embodiments, variations and/ or modifications of the present disclosure, and may not create any limitations, particularly as to the order, or preference, of any element, embodiment, variation and/or modification relative to, or over, another element, embodiment, variation and/or modification.

It will also be appreciated that one or more of the elements depicted in the drawings/figures can also be implemented in a more separated or integrated manner, or even removed in certain cases, as is useful in accordance with a particular application.

For expository purposes, the term "horizontal" as used herein is defined as a plane parallel to the plane or surface of the floor of the area in which the device being described is used or the method being described is performed, regardless of its orientation. The term "floor" can be interchanged with the term "ground." The term "vertical" refers to a direction perpendicular to the horizontal as just defined. Terms such as "above," "below," "bottom," "top," "side," "front," "rear," "lateral," "higher," "lower," "upper," "over," and "under," are defined with respect to the horizontal plane, in use.

The terms "comprising," "including," "having," and the like are synonymous and are used inclusively, in an open-ended fashion, and do not exclude additional elements, features, acts, operations, and so forth. Also, the term "or" is used in its inclusive sense (and not in its exclusive sense) so that when used, for example, to connect a list of elements, the term "or" means one, some, or all of the elements in the list.

Although certain embodiments and examples have been described herein, it will be understood by those skilled in the art that many aspects of the systems shown and described in the present disclosure may be differently combined and/or modified to form still further embodiments or acceptable examples. All such modifications and variations are intended to be included herein within the scope of this disclosure. A wide variety of designs and approaches are possible. No feature, structure, or step disclosed herein is essential or indispensable.

For purposes of this disclosure, certain aspects, advantages, and novel features are described herein. It is to be understood that not necessarily all such advantages may be achieved in accordance with any particular embodiment. Thus, for example, those skilled in the art will recognize that the disclosure may be embodied or carried out in a manner that achieves one advantage or a group of advantages as taught herein without necessarily achieving other advantages as may be taught or suggested herein.

Moreover, while illustrative embodiments have been described herein, the scope of any and all embodiments having equivalent elements, modifications, omissions, combinations (e.g., of aspects across various embodiments), adaptations and/or alterations as would be appreciated by those in the art based on the present disclosure. The limitations in the claims are to be interpreted broadly based on the language employed in the claims and not limited to the examples described in the present specification or during the prosecution of the application, which examples are to be construed as non-exclusive. Further, the actions of the disclosed processes and methods may be modified in any manner, including by reordering actions and/or inserting additional actions and/or deleting actions. It is intended, therefore, that the specification and examples be considered as illustrative only, with a true scope and spirit being indicated by the claims and their full scope of equivalents.

Conditional language used herein, such as, among others, "can," "might," "may," "e.g.," and the like, unless specifically stated otherwise, or otherwise understood within the context as used, is generally intended to convey that some embodiments include, while other embodiments do not include, certain features, elements, and/or states. Thus, such conditional language is not generally intended to imply that features, elements, blocks, and/or states are in any way required for one or more embodiments or that one or more embodiments necessarily include logic for deciding, with or without author input or prompting, whether these features, elements and/or states are included or are to be performed in any particular embodiment.

The ranges disclosed herein also encompass any and all overlap, sub-ranges, and combinations thereof. Language such as "up to," "at least," "greater than," "less than," "between," and the like includes the number recited.

## Claims

1. A threadless fastener system for securing a printed circuit board assembly (PCBA) to an attachment pin, the attachment pin extending from a heatsink and comprising a clamping surface spaced from the heatsink and configured to support the PCBA, the system comprising:
a fastening washer having a conical spring and a plurality of interference petals, the plurality of interference petals being sized and shaped to clamp to the attachment pin; and
a retaining cup sized and shaped to receive the fastening washer, a portion of the retaining cup being disposed between the fastening washer and the PCBA when the plurality of interference petals are clamped to the attachment pin,
wherein the conical spring creates a thermally stable clamping force on the PCBA between the clamping surface and the portion of the retaining cup when the plurality of interference petals are clamped to the attachment pin.

2. A fastening washer configured for securement to an attachment pin, the fastening washer comprising:
a conical spring having an inner edge and an outer edge;
a flat outer rim extending from the outer edge of the conical spring;
an integrated press surface extending inward from the inner edge; and
a plurality of interference petals arranged inward from the integrated press surface.

3. The fastening washer of claim 2, further comprising an opening at a center of the plurality of interference petals, preferably wherein a diameter of the opening is about 2.75 mm.

4. The fastening washer of claim 2 or 3, wherein the inner edge and the outer edge are circular and concentric; and/or wherein the integrated press surface is substantially parallel to the flat outer rim.

5. The fastening washer of one of claims 2 to 4, further comprising one or more gaps extending radially through a portion of the conical spring.

6. The fastening washer of one of claims 2 to 5, wherein the plurality of interference petals are configured to mechanically grip the attachment pin.

7. The fastening washer of one of claims 2 to 6, wherein the fastening washer further comprises stainless steel.

8. The fastening washer of one of claims 2 to 7, wherein the fastening washer further comprises a height from the flat outer rim to the plurality of interference petals, wherein the height is about 2 mm, and/or wherein an outer diameter of the flat outer rim is about 13 mm.

9. A threadless fastener system comprising:
a retaining cup having a cup clamping surface;
a fastening washer comprising a conical spring positioned within the retaining cup, the fastener washer preferably as defined in one of claims 2 to 8; and
an attachment pin having an interface surface and a pin clamping surface;
wherein an end of the attachment pin is configured to attach to a first item, wherein the fastening washer is configured to clamp on the interface surface, and wherein the conical spring is configured to generate a clamping force on a second item positioned between the cup clamping surface and the pin clamping surface.

10. The threadless fastener system of claim 9, wherein the cup clamping surface is spaced a distance away from the end of the attachment pin.

11. The threadless fastener system of claim 9 or 10, wherein the interface surface is electrically conductive.

12. The threadless fastener system of one of claims 9 to 11, wherein the retaining cup further comprises one or more washer centering wedges; and/or
wherein the clamping force is at least 300 N.

13. The threadless fastener system of one of claims 9 to 12, wherein the retaining cup further comprises a washer press distance limiting feature.

14. The threadless fastener system of one of claims 9 to 13, wherein the retaining cup further comprises one or more snap retainers.

15. The threadless fastener system of one of claims 9 to 14, wherein the first item is a heatsink and wherein the heatsink is fixedly attached to the attachment pin; and/or wherein the second item is a PCBA.
